# EUROPEAN PATENT APPLICATION

(11) **EP 2 631 661 A1**
(43) Date of publication of application: **28.08.2013**
(21) Application number: 12745096.3
(22) Date of filing: 25.01.2012
(51) Int. Cl.: G01R 29/24, G01R 29/08, G01R 29/12

(54) **METHOD AND APPARATUS FOR MEASURING ELECTROSTATIC CHARGE**

(30) Priority: 09.02.2011 JP 2011025542
(71) Applicant: National Institute of Advanced Industrial Science and Technology, Tokyo 100-8921 (JP)
(72) Inventor: KIKUNAGA Kazuya, Tosu-shi, Saga 841-0052 (JP); NONAKA Kazuhiro, Tosu-shi, Saga 841-0052 (JP)
(74) Representative: Prüfer & Partner GbR European Patent Attorneys
(86) International application number: PCT/JP2012/051492
(87) International publication number: WO 2012/108258

(57) **Abstract**

[Problem to be Solved] A static-electricity electrification measurement method and apparatus that satisfy, at the same time, three conditions: (1) to measure static-electricity electrification non-destructively, (2) to reduce environmental influence of a measured object wherein metals and insulators are mixed to measure the static-electricity electrification, and (3) to measure the static-electricity electrification without getting close thereto is provided.

[Solution] A static-electricity electrification measurement method of the present invention includes: an adding step of adding vibrations having a vibration frequency and an amplitude selected in advance to a measured object; an intensity measuring step of measuring intensity of electromagnetic waves generated along with the vibrations of the measured object; and a state measuring step of measuring a static-electricity electrification state of the measured object based on intensity of the electromagnetic waves measured in the measuring step.

## Description

### Technical Field

The present invention relates to a static-electricity electrification measurement method and apparatus for measuring and managing static-electricity electrification generated in various manufacturing sites of, for example, semiconductor manufacturing, electronic device manufacturing, precision machine manufacturing, medicine manufacturing, and food manufacturing.

### Background Art

Static electricity is irregularly generated in various manufacturing sites and serves as a cause that induces not only destruction of parts and products but also failure/disaster such as fire. As a specific example, static electricity is often generated in semiconductor manufacturing sites. Electronic elements such as ICs and LSIs manufactured in semiconductor manufacturing sites, electronic boards on which they are mounted, and electronic devices in which the electronic boards are incorporated are extremely vulnerable to static electricity. The static electricity which generates such problems is generated when devices/apparatuses/people electrified by contact, peel-off, discharge, etc. are brought into contact with other objects. The generated static electricity causes failure such as electrostatic destruction, malfunction, etc. of electronic devices.

Polymer materials are insulators having extremely large electric resistivity. Therefore, when a polymer material is electrified with a large amount of static electricity, discharge generated by the material per se or an object induced by the material may ignite a flammable substance. It has been reported that the ignition may be expanded to explosion/fire. Furthermore, since attracting/repelling actions of static electricity cause large failure of static electricity troubles such as contamination or dust adhesion of raw materials, semi-manufactured products, and products, there is a situation that static electricity control is essential in manufacturing sites of electronic/chemical industries, precision machine industries, pharmaceutical industries, food industries, etc.

In order to prevent occurrence of accidents caused along such static electricity, as a matter of course, it is important to prevent generation of static electricity in manufacturing sites. For example, when a worker who handles chips such as semiconductors wears a grounding band, generation of static-electricity electrification can be prevented. Alternatively, an insulating part of a manufacturing line is provided with electrical conductivity by applying electrically-conductive painting or coating of a surfactant agent thereto so as to prevent electrification with static electricity. Also, a measure such as removal of electrification without contact is sometimes made by, for example, an ionizer. However, such a measure is sometimes insufficient depending on the magnitude of static electricity. Since the effects of electrification removal/suppression by the measures are deteriorated along with time, the same measure operations have to be periodically repeated. The repetition of the measure operations causes increase in cost and reduction in productivity.

Therefore, in manufacturing sites, static-electricity electrification generated during steps of manufacturing steps is measured in a simple manner, factors of static electricity generation are analyzed, and the steps per se are sometimes reviewed. For example, in the manufacturing sites, materials which are not easily electrified are selected, or manufacturing step conditions such as contact speeds and pressures are changed. Alternatively, a static-electricity removing process is taken into steps at appropriate and requisite minimum timing.

In such countermeasures of step reviewing, development of measurement techniques for realizing management of static-electricity electrification at low cost is desired.

However, in a manufacturing site of, for example, semiconductor manufacturing, products are continuously flowing between steps. Therefore, measurement techniques of static-electricity electrification requires that static-electricity electrification can be measured non-destructively so as not to reduce production efficiency and that the environment of the measured object where metals and insulators are mixed does not affect the measurement. Furthermore, a measurement apparatus of static-electricity electrification is required to satisfy a condition that static-electricity electrification of a measured object can be remotely measured even when there are spatial restrictions due to, for example, manufacturing apparatuses.

As techniques about such static-electricity electrification measurement, a technique in which a surface electrometer is used (for example, see Patent Publication 1) and a technique in which a Pockeles element using a first-order electro-optical effect and a CCD camera are used (for example, see Patent Publication 2) have been proposed.

However, since the technique of Non-Patent Publication 1 is easily affected by an environment since electric-force lines are attracted by metals/grounds therearound in an actual manufacturing site, close measurement in which a probe is caused to be close to a sample has to be carried out. Therefore, remote measurement and spatial resolving power have a relation of inverse proportion, and the technique of Non-Patent Publication 1 has a problem that static-electricity electrification cannot be measured at high accuracy.

The technique of Non-Patent Publication 2 has an advantage of high-speed measurement of two-dimensional distribution. However, it is limited to a measured object having the Pockels effect, and static-electricity electrification has to be measured while causing a Pockels crystal plate to be close to the measured object. More specifically, since precise static-electricity electrification measurement is difficult, usage in a manufacturing site with many spatial restrictions is difficult.

Alternatively, a pressure wave method (for example, see Non-Patent Publication 3) and a pulse static-electricity acoustic method (for example, see Non-Patent Publication 4) have been proposed.

However, since all of the techniques of Non-Patent Publication 3 and Non-Patent Publication 4 are the techniques which measure charge distribution in a solid matter by a contact method of directly bringing an electrode into contact with a lateral surface of a measured object, there is a problem that the techniques cannot be easily applied to manufacturing sites.

Furthermore, a technique that measures spatial charge distribution by radiating sound waves to the air and obtaining changes of electric fields radiated from floating charge by the positions thereof from sound-wave speeds and detection time has been proposed (for example, see Non-Patent Document 5).

However, charge floating in the air is a measured object in this case, and the measurement field is disturbed by the sound waves. Therefore, there are many defects such as low reproducibility and bad sensitivity.

On the other hand, although they are not for static-electricity electrification measurement, techniques that utilize the principle that electromagnetic waves are induced when a sound-wave converging beam is radiated to a part of a measured object with many charged particles has been also proposed (for example, see Non-Patent Publication 6, Patent Publication 1). Upon activation of neurons, Na ions are spread in cells based on a concentration gradient and form charge distribution. When sound waves are converged to the region of the charge distribution and the intensity of induced electromagnetic waves is measured, activities of the neurons are directly measured.

However, the techniques of Non-Patent Publication 6 and Patent Publication 1 have problems that they require a medium such as water since they are on a condition of usage of ultrasonic waves. Moreover, for example if the measured object is GaAs, a detected signal is notably as low as 68 µV with amplification of 82 dB (about 12000 times), and other examples also have proved that it is extremely low as nV order. As a result, there is a problem that detected electromagnetic-wave intensity is extremely minute. This is due to the characteristic of a piezoelectric material in which polarization occurs when a sound pressure is applied thereto, and the techniques of Non-Patent Publication 6 and Patent Publication 1 are not suitable for a manufacturing site in which various electrified materials are mixed. Moreover, the techniques of Non-Patent Publication 6 and Patent Publication 1 are not suitable for a manufacturing site also from a point that a radio shielding room is required since the electromagnetic-wave intensity is extremely minute.

Moreover, a technique of disposing a measured object in a fluid, radiating sound waves thereto, and measuring electric signals or magnetic signals generated in the fluid at a boundary layer of the measured object has been proposed (for example, see Patent Publication 2). The technique of Patent Publication 2 is capable of detecting chemical characteristics and biological characteristics of the measured object, but has a problem that contact with an electrode is required since the signals are directly measured by the electrode.

### Citation List

### Patent Publication

Patent Publication 1: International Republished Publication No. WO2007-055057
Patent Publication 2: Japanese Patent Publication No. 2004-512528

### Non Patent Publication

Non Patent Publication 1: H. Onomae: Kagoshima prefectural Institute of Industrial Technology research report, No. 20, pp. 57 to 63 (2006)
Non Patent Publication 2: A. Kanno, K. Sasagawa, T. Shiozawa, and M. Tsuchiya: Optics Express 18 (2010) 10029 to 10035 Non Patent Publication 3: E. Eisenmenger, M. Haardt: Solid St. Comm. 41 (1982) 2769 to 2775
Non Patent Publication 4: T. Maeda, Y. Oki, A. Nishikata, T. Maeno: Trans. Inst. Elect. Engnr. Jpn. A 126 (2006) 185 to 190
Non Patent Publication 5: A. Hazmi, N. Takagi, D. Wang and T. Watanabe: Sensors 7 (2007) 3058 to 3070
Non Patent Publication 6: K. Ikushima, S. Watanuki, S. Komiyama: Appl. Phys. Lett. 89 (2006) 194103

### Summary of Invention

### Technical Problem

Generally, electrification occurs in any material (metal, semiconductor, insulator); wherein, in a metal, the surface thereof is uniformly electrified, and a semiconductor or an insulator is non-uniformly and randomly electrified with positive and negative charge. In a manufacturing site of, for example, semiconductor manufacturing, the risk of electrification of electronic elements that leads to, for example, destruction of electronic elements is as described above.

Herein, positive electrification of an electronic element means that the electric potential thereof is high, and discharge is caused when the electrified electronic element is brought into contact with an object having a different electric potential such as an adjacent electronic element, a ground, or a negatively-charged different element.

Particularly, in the case of the electronic element, electrification of each electronic element is problematic. Therefore, the static-electricity electrification of the electronic element has to be measured by a simple method without disturbing the flow of a manufacturing line.

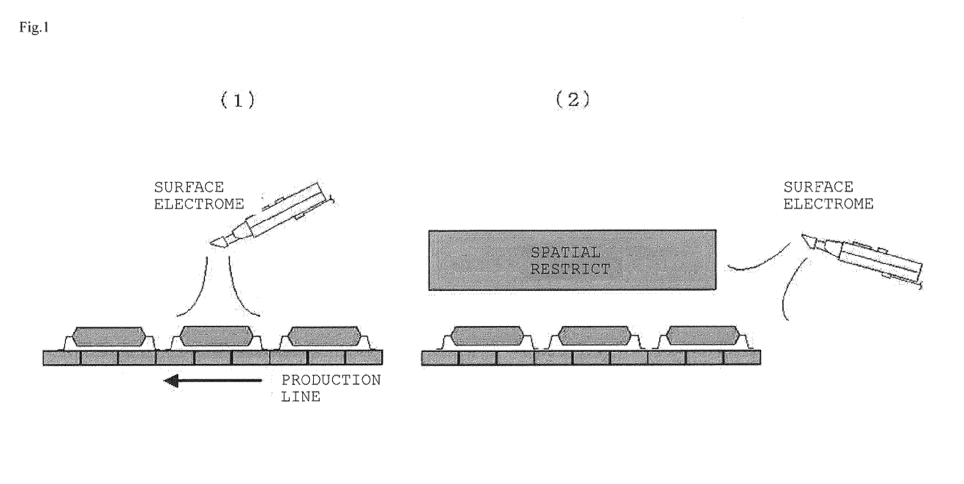

In a case in which an existing surface electrometer is used in measurement of static-electricity electrification of an electronic element, the static-electricity electrification can be measured in a case like FIG. 1 (1). However, in an actual semiconductor manufacturing line, various devices are often disposed above the manufacturing line. If the surface electrometer is disposed above the manufacturing line, spatial restrictions are exerted since minute dust may be induced. For example, avoiding the part immediately above the manufacturing line, the surface electrometer is disposed obliquely above the manufacturing line like FIG. 1 (2). In measurement at such an obliquely above part, the measured electric potential is not precise or is affected by the influence therearound (for example, if there is a ground part, an electric field is attracted thereto), and the measured electric potential therefore becomes larger or smaller than the original electric potential. As a result, as a matter of course, the magnitude of the measured static-electricity electrification is not precise.

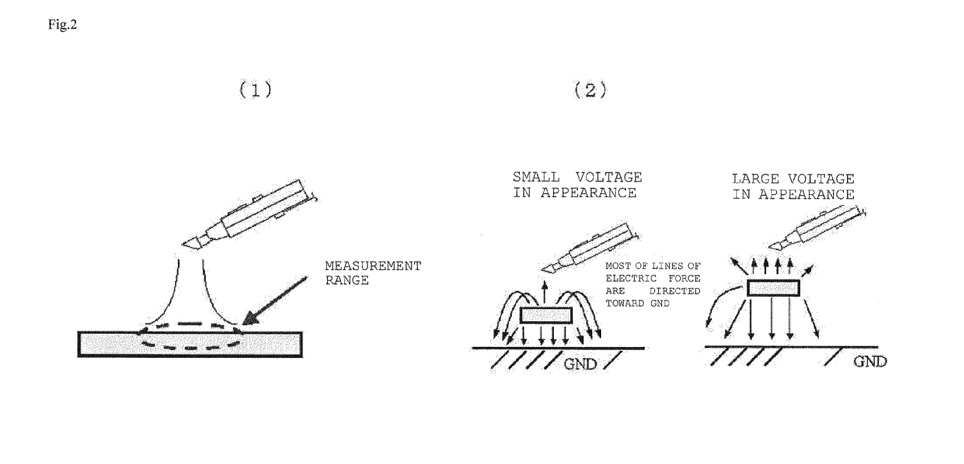

Moreover, normally, in a case in which partial static-electricity electrification is to be measured, a non-contact-type surface electrometer is often used. However, as shown in FIG. 2 (1), the measurement range of the surface electrometer is expanded when the measurement distance is long. Therefore, remote measurement and spatial resolving power are in an inverse proportional relation. The surface electrometer has a large error when a ground is present therearound as shown in FIG. 2 (2) or another electrified object is present.

Moreover, generally, when the static-electricity electrification amount of an entire measured object is to be measured, a "Faraday cage" for calculating the static-electricity electrification amount by placing the measured object in an electrically-conductive case and measuring the electric potential of an inner conductor container generated when an electrified object is placed in a double conductor container separated into the inner part and an outer part is required. Therefore, contact with the measured object is required, and reproducibility is poor.

Therefore, it is an object of the present invention to provide a static-electricity electrification measurement method and apparatus that adds vibrations to a measured object and measures electromagnetic waves (electric waves or electromagnetic fields) generated along with the vibrations of the static-electricity electrification of the measured object, thereby satisfying, at the same time, three conditions: (1) to measure the static-electricity electrification non-destructively, (2) to reduce environmental influence of the measured object wherein metals and insulators are mixed to measure the static-electricity electrification, and (3) to measure the static-electricity electrification without getting close thereto.

### Solution to Problem

In static-electricity electrification measurement techniques of the present invention, generated electromagnetic waves (electric waves or electromagnetic fields) are measured by adding spatial vibrations to an electrified measured object or thereto together with a measurement location.

As a result of experiments, it was confirmed that, when vibrations were added to a measured object electrified by, for example, sound waves, electromagnetic waves synchronized with the vibrating frequency was detected. In addition, electromagnetic waves following the sound waves such as sine waves or square waves were observed in the form of fundamental waves or harmonic waves. According to these results, the characteristics of the electromagnetic waves generated from the electrified measured object can be controlled by controlling the vibrations added to the measured object. It is conceived that the static-electricity electrification, amount of the measured object can be measured based on the characteristics of the electromagnetic waves generated from the measured object.

Moreover, according to an experiment in which the same vibrations were added to an electrified measured object and only the electric potential of the measured object was changed, it was confirmed that the surface electric potential and electromagnetic-wave intensity thereof were in a proportional relation and that the phases of the measured electromagnetic waves were different depending on positive or negative of the electric potential of the measured object. Therefore, when these phenomena are used, the static-electricity electrification state of the measured object can be measured by measuring the electromagnetic waves having the same frequency as the vibration frequency added to the measured object.

In measurement experiments with respect to an unevenly-electrified insulating film, the results of the static-electricity electrification distribution measured by a surface electrometer and the static-electricity electrification distribution measured by the method of the present invention matched. Therefore, this method is effective in electrification measurement.

More specifically, the static-electricity electrification measurement method of the present invention is described as below.

The static-electricity electrification measurement method according to a first invention includes an adding step of adding vibrations having a vibration frequency and an amplitude selected in advance to a measured object; an intensity measuring step of measuring intensity of electromagnetic waves generated along with the vibrations of the measured object; and a state measuring step of measuring a static-electricity electrification state of the measured object based on the intensity of the electromagnetic waves measured in the measuring step.

In addition to the first invention, the static-electricity electrification measurement method according to a second invention further includes an amplitude measuring step of measuring an amplitude of the measured object; and an electrification-amount measuring step of measuring a static-electricity electrification amount of the measured object based on the intensity of the electromagnetic waves measured in the intensity measuring step and the amplitude measured in the amplitude measuring step.

In addition to the first or second invention, the static-electricity electrification measurement method according to a third invention further includes a determination step of determining whether the static-electricity electrification state of the measured object is negative electrification or positive electrification based on a phase of the electromagnetic waves measured in at least one of the intensity measuring step and the amplitude measuring step.

In addition to any of the first to third inventions, in the static-electricity electrification measurement method according to a fourth invention, in the adding step, sound waves having the vibration frequency and a sound pressure selected in advance are radiated to the measured object.

In addition to any of the first to third inventions, the static-electricity electrification measurement method according to a fifth invention, in the adding step, a supporting mount supporting the measured object is vibrated at the vibration frequency and the amplitude selected in advance.

In addition to the fourth invention, in the static-electricity electrification measurement method according to a sixth invention, in the adding step, a sound-wave generator that is installed at a bottom part of a cylindrical member and generates the sound waves is provided; and the measured object is disposed above the cylindrical member.

In addition to the fourth invention, in the static-electricity electrification measurement method according to a seventh invention, in the adding step, the sound waves are converged by a sound-wave converging unit and add local vibrations to the measured object.

In addition to the seventh invention, in the static-electricity electrification measurement method according to the eighth invention, the sound-wave converging unit uses at least one of a conical member, a circular concave lens, an acoustic lens, and electronic focusing using a plurality of sound sources for converging the sound waves generated from the sound-wave generator.

In addition to any of the first to third inventions, the static-electricity electrification measurement method according to a ninth invention, in the adding step, a vibrator having an end to be in contact with the measured object is provided; and the vibrator and the measured object are brought into contact with each other and vibrated at the vibration frequency and the amplitude selected in advance.

In addition to any of the seventh to ninth inventions, in the static-electricity electrification measurement method according to a tenth invention, in the adding step, a position of adding the vibrations to the measured object is scanned; and in the intensity measuring step, static-electricity electrification distribution of the measured object is measured by measuring the electromagnetic waves in correspondence with the scanned position.

A static-electricity electrification measurement apparatus according to an eleventh invention has: a vibration adding unit operable to add vibrations having a predetermined amplitude and frequency to a measured object; a receiving unit operable to receive electromagnetic waves generated along with the vibrations of the measured object; and a calculating unit operable to calculate a static-electricity electrification amount, which has electrified the measured object, based on intensity of the electromagnetic waves received by the receiving unit.

In addition to the eleventh invention, the static-electricity electrification measurement apparatus according to a twelfth invention further has a laser displacement meter that measures an amplitude of the measured object.

In addition to the eleventh or twelfth invention, in the static-electricity electrification measurement apparatus according to a thirteenth invention, the calculating unit further has a determination unit operable to determine whether the static-electricity electrification of the measured object is negative electrification or positive electrification based on a phase of the electromagnetic waves received by the receiving unit.

In addition to any of the eleventh to thirteenth inventions, in the static-electricity electrification measurement apparatus according to a fourteenth invention, the vibration adding unit has a sound-wave generating device operable to radiate sound waves having a vibration frequency and a sound pressure selected in advance to the measured obj ect.

In addition to any of the eleventh to thirteenth inventions, in the static-electricity electrification measurement apparatus according to a fifteenth invention, the vibration adding unit has a vibration generating device operable to vibrate a supporting mount supporting the measured object at the vibration frequency and the amplitude selected in advance.

In addition to the fourteenth invention, in the static-electricity electrification measurement apparatus according to a sixteenth invention, the sound-wave generating device has a sound-wave generator installed at a bottom part of a cylindrical member; and the sound-wave generator radiates the sound waves to the measured object disposed above the cylindrical member.

In addition to the fourteenth invention, in the static-electricity electrification measurement apparatus according to a seventeenth invention, the sound-wave generating device has at least one of a sound-wave generator, a circular concave lens, an acoustic lens, and electronic focusing using a plurality of sound sources installed at a bottom part of a conical member; and the sound-wave generating device radiates converged sound waves to the measured object.

In addition to any of eleventh to thirteenth inventions, in the static-electricity electrification measurement apparatus according to an eighteenth invention, the vibration adding unit has a vibrator provided with an end to be in contact with the measured object; and the vibrator adds the vibrations at the vibration frequency and the amplitude selected in advance at a contact point with the measured object.

In addition to the seventeenth or eighteenth invention, in the static-electricity electrification measurement apparatus according to a nineteenth invention, the vibration adding unit has an x-y stage that carries out scanning with respect to the measured object; and the calculating unit measures static-electricity electrification distribution of the measured object by measuring the electromagnetic waves in correspondence with a scanning position of the x-y stage. Advantageous Effects of Invention

In the static-electricity electrification measurement method of the present invention, the static-electricity electrification state of the measured object can be measured by adding vibrations to the measured object and measuring the intensity of the electromagnetic waves (electric waves or electromagnetic fields) generated along with the vibrations of the static-electricity electrification of the measured object. As a result, even when a grounded part or a location having a high electric potential is present around the measured object, by separating them from the vibrations, measurement without contact can be carried out without being affected by them. More specifically, in the static-electricity electrification measurement method, the static-electricity electrification state can be precisely measured without affecting the static-electricity electrification state of the measured object. In addition, an antenna which detects the electromagnetic waves can be freely installed within a detectable region; therefore, even when there are spatial restrictions around the measured object, the static-electricity electrification can be measured by the static-electricity electrification measurement method without being restricted by the spatial restrictions.

In that process, when the amplitude of the measured object is measured, the static-electricity electrification amount can be measured from the relation with the intensity of the electromagnetic waves, and whether the static-electricity electrification state is negative electrification or positive electrification can be determined from the phase of the electromagnetic waves.

Furthermore, by adding local vibrations to the measured object and scanning the location of the vibrations, the static-electricity electrification distribution of the surface of the measured obj ect can be measured from the relation between the vibration-added position and the electromagnetic-wave intensity at that point by the static-electricity electrification measurement method of the present invention.

### Brief Description of the Drawings

[Figure 1] FIG. 1 shows drawings showing spatial restrictions of measurement by a surface electrometer.
[Figure 2] FIG. 2 shows drawings showing influence caused by an environment of measurement by the surface electrometer.
[Figure 3] FIG. 3 shows drawings showing basic principles of the present invention.
[Figure 4] FIG. 4 shows drawings showing the degree of freedom of installation in the present invention.
[Figure 5] FIG. 5 is a drawing showing an embodiment of the present invention.
[Figure 6] FIG. 6 is a drawing showing measurement results of electromagnetic-wave intensity of the embodiment.
[Figure 7] FIG. 7 is a drawing showing measurement results of electromagnetic-wave intensity of a case in which the frequency of radiated sound waves is changed.
[Figure 8] FIG. 8 shows drawings showing another embodiment of the present invention.
[Figure 9] FIG. 9 shows drawings showing measurement results of electromagnetic-wave intensity in a case of negative electrification and a case of positive electrification in the embodiment.
[Figure 10] FIG. 10 shows drawings showing phases of electromagnetic waves measured in a case of negative electrification and a case of positive electrification in the embodiment.
[Figure 11] FIG. 11 is a drawing showing further another embodiment of the present invention.
[Figure 12] FIG. 12 is a drawing showing the relation between measured electromagnetic-wave intensity and amplitudes added to a measured object in the embodiment.
[Figure 13] FIG. 13 is a drawing showing further another embodiment of the present invention.
[Figure 14] FIG. 14 shows drawings showingmeasurement results of charge distribution according to a static-electricity electrification measurement method of the present invention.
[Figure 15] FIG. 15 shows measurement results using a surface electrometer for verifying the measurement results of the charge distribution according to the static-electricity electrification measurement method of the present invention.

### Description of Embodiments

Hereinafter, embodiments of the present invention will be explained with reference to drawings.

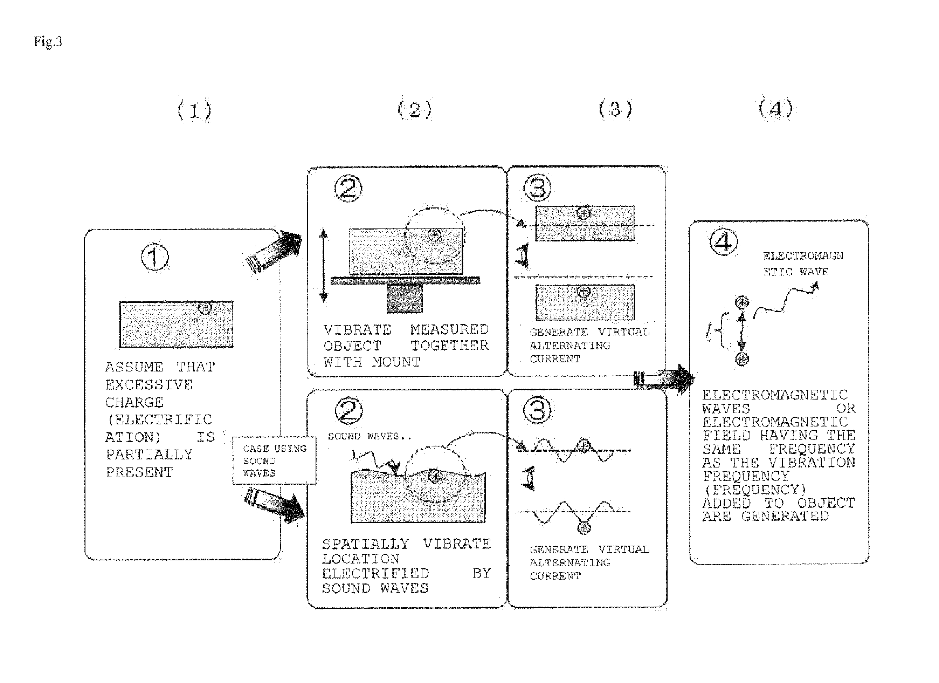

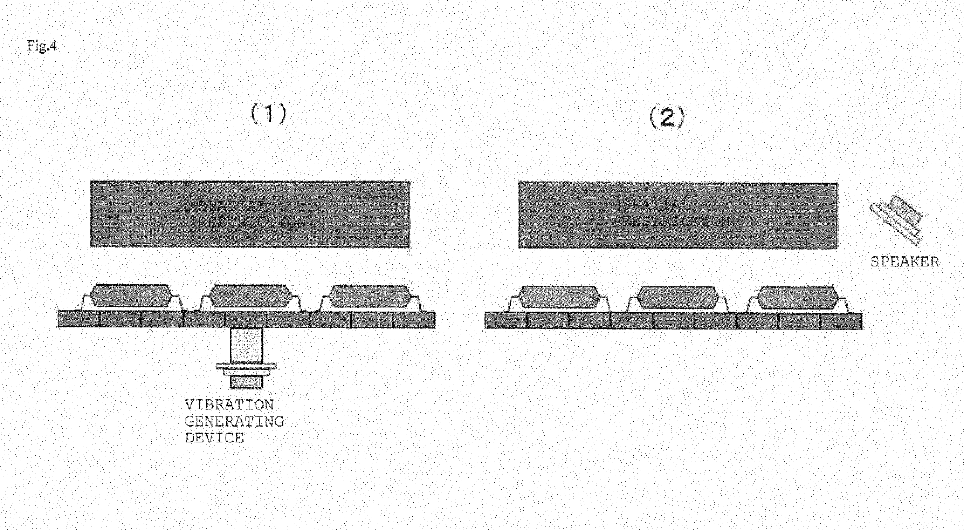

First, basic principles of a static-electricity electrification measurement method of the present invention will be explained. FIG. 1 shows drawings showing spatial restrictions of the measurement using a surface electrometer. FIG. 2 shows drawings showing influence caused by the environment of the measurement using the surface electrometer. FIG. 3 shows drawings showing the basic principles of the present invention. FIG. 4 shows drawings showing the degree of freedom of installation in the present invention.

The static-electricity electrification measurement method of the present invention has: an adding step of adding vibrations having a vibration frequency and an amplitude, which have been selected in advance, to a measured object; an intensity measuring step of measuring the intensity of electromagnetic waves, which are generated along with the vibrations of the measured object; and a state measuring step of measuring a static-electricity electrification state of the measured object based on the intensity of the electromagnetic waves measured in the measuring step. By virtue of this configuration, the intensity of the electromagnetic waves based on the vibrations, which have been added to the measured object in the adding step, is measured in the intensity measuring step. The measured intensity of the electromagnetic waves represents the static-electricity electrification state including an electrification amount of the static-electricity electrification of the measured object, and this static-electricity electrification state is measured in the state measuring step. As a result, the static-electricity electrification amount (including the polarity of static-electricity electrification, etc.) of the measured object is measured by the static-electricity measurement method of the present invention.

Similarly, a static-electricity electrification measurement apparatus which realizes the static-electricity electrification measurement method of the present invention has: a vibration adding unit, which adds vibrations having the predetermined amplitude and frequency to the measured object; a receiving unit, which receives the electromagnetic waves generated along with the vibrations of the measured object; and a calculating unit, which calculates the static-electricity electrification amount which has electrified the measured object based on the intensity of the electromagnetic waves received by the receiving unit.

The vibration adding unit adds vibrations to the measured object with various units. The vibration frequency thereof is determined in advance in accordance with characteristics, etc. of the measured object. The measured object generates virtual electromagnetic waves by the added vibrations. The virtual electromagnetic waves are electromagnetic waves caused by up-down movement of the electrification charge that the measured object has. The receiving unit receives the electromagnetic waves generated by the measured object. The receiving unit outputs the received electromagnetic waves to the calculating unit. The calculating unit calculates the static-electricity electrification amount, which has electrified the measured object, based on the obtained electromagnetic waves. Not only the static-electricity electrification amount, but also the state of polarity of the static-electricity charge, etc. is calculated.

Since the vibrations and reception can be carried out in a mutually separated and distant state with the static-electricity electrification measurement apparatus, the receiving unit and the calculating unit can be separated and distant from the measured object. Therefore, the receiving unit and the calculating unit are not required to be in contact with the measured object, which flows in a manufacturing line; therefore, even when there are spatial restrictions, the static-electricity electrification measurement apparatus can measure the static-electricity electrification state of the measured object. Since the vibration adding unit is only required to directly or indirectly vibrate the measured object, the vibration adding unit can also vibrate the measured object regardless of the spatial restrictions. Also from this point, the static-electricity electrification measurement apparatus can be easily installed at a manufacturing site.

An explanation will be given herein by taking a case in which a surface of the measured object is electrified with a positive charge as an example. With respect to the measured object of which surface is positively electrified as shown in FIG. 3 (1), sound waves are radiated to the surface as shown in FIG. 3 (2). Alternatively, the vibrations are added to a mount supporting the measured object. As a result, along with the vibrations of the measured object (not only the vibrations of the entire measured object, but also the vibrations in the region in which the sound waves are added to the measured object), the positive charge vibrates as shown in FIG. 3 (3). Furthermore, as shown in FIG. 3 (4), electromagnetic waves having the same frequency as that of the vibration frequency added to the measured object are generated.

When the measured object is to be vibrated in this manner, the electrification state of static electricity has to be configured to not to be changed by the vibrations both in the case in which the sound waves are radiated to the measured object and in the case in which the vibrations are to be added to the supporting mount.

In this manner, in the static-electricity electrification measurement method of the present embodiment, the electromagnetic waves can be generated only by vibrating the measured object together with the mount or radiating the sound waves to the measured object to vibrate the object. Moreover, based on the electromagnetic waves having the same frequency as the vibration frequency, the static-electricity electrification amount of the measured object can be precisely detected in the static-electricity electrification measurement method.

The measured object can be vibrated together with the mount by installing a vibration generating device, which vibrates the measured object, at part of a conveyance line like FIG. 4 (1). Alternatively, the measured object can be subjected to radiation with sound waves and vibrated by disposing a sound-wave generating device such as a speaker at a location that avoids spatial restrictions as shown in FIG. 4 (2) and radiating sound waves to the object. In this process, when electromagnetic waves are measured by the antenna disposed at an appropriate location, that avoids the spatial restrictions, the static-electricity electrification amount of the measured object can be precisely measured.

### (Example of the Static-Electricity Electrification Measurement Method)

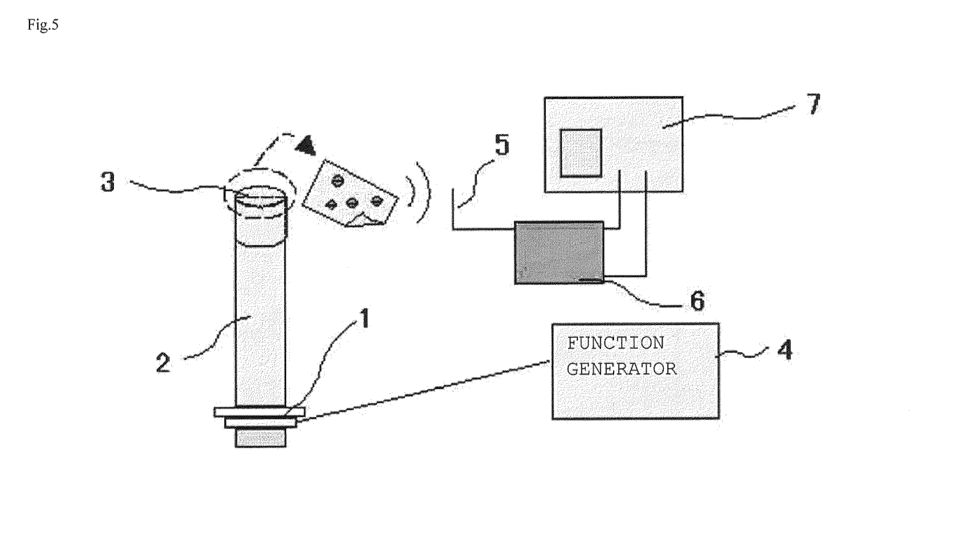

Next, a specific example will be explained based on drawings. FIG. 5 is a drawing showing an example of the present invention.

As shown in FIG. 5, an acrylic tube 2 having a diameter of 60 mm, a height of 1 m, and a thickness of 5 mm is placed on a vibrating surface of a speaker 1 serving as a sound-wave generator. A polyimide film 3 serving as a measured object is attached to an upper-surface opening of the acrylic tube 2, and the speaker 1 attached to a lower-surface opening of the acrylic tube 2 is driven via a function generator 4. As a result of this drive, sound waves having a frequency of 2 to 10 Hz are radiated to the polyimide film 3 serving as the measured object. The time dependency of the electromagnetic-wave intensity is measured by an oscilloscope 7 via a monopole antenna 5 and a preamplifier 6. The static-electricity electrification amount of the polyimide film 3 serving as the measured object is measured in accordance with the time dependency.

In this example, the acrylic tube 2 is used for not spreading the sound pressure of the speaker 1. When sound waves of 2 to 10 Hz generated from the speaker 1 are radiated to the interior of the acrylic tube, the speaker 1 and the acrylic tube 2, which vibrate the polyimide film 3 at an amplitude of about 1 to 3 mm, constitute a sound-wave radiating apparatus.

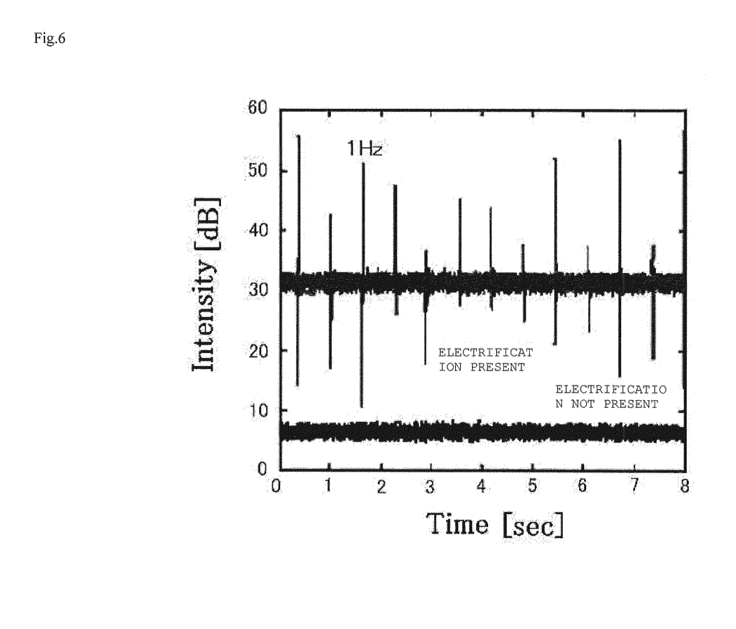

FIG. 6 shows measurement results of a case in which the polyimide film 3 was not electrified and a case in which the film was electrified when sound waves of 2 Hz are radiated to the interior of the acrylic tube by the speaker 1. FIG. 6 is the drawing which shows the measurement results of the electromagnetic-wave intensity of this example.

As is understood from these measurement results, when there was no electrification, the electromagnetic-wave intensity was not changed regardless of the sound-wave radiation of 2 Hz; on the other hand, when there was electrification, large changes of about ±20 dB was observed in the electromagnetic-wave intensity in synchronization with the frequency of the sound waves.

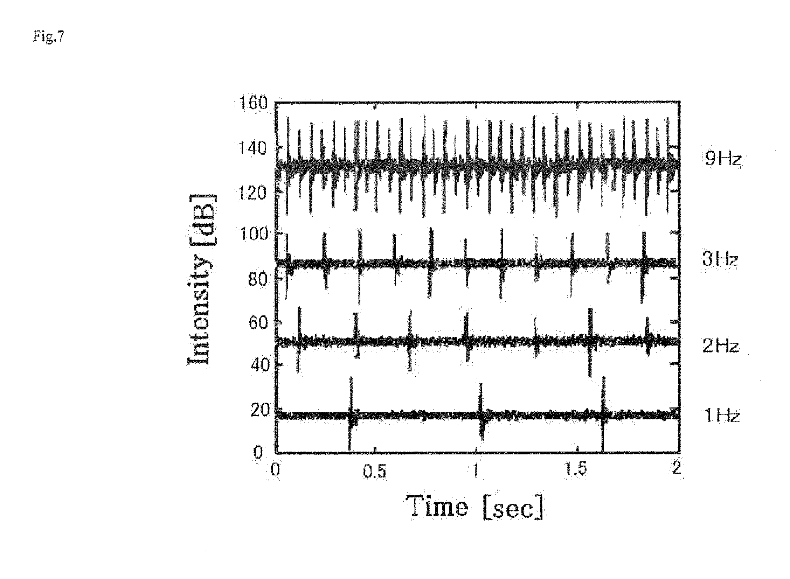

FIG. 7 is a drawing showing measurement results of electromagnetic-wave intensity of a case in which the frequency of the radiated sound waves is changed. FIG. 7 shows the measurement results of the case in which the vibration frequency of the sound waves radiated by the speaker 1 was sequentially changed from 2 Hz to 10 Hz (however, the electrification amount was different from that of FIG. 6). It can be understood from FIG. 7 that the electromagnetic-wave intensity was changed to follow the vibration frequencies of the sound waves radiated by the speaker 1. The vibration frequency of the sound waves radiated by the speaker 1 also affects the amplitude of the measured object, and the amplitude of the measured object largely affects the generated electromagnetic-wave intensity. Therefore, an optimal vibration frequency has to be selected in accordance with the material, shape, and thickness of the measured object.

The vibration frequency also depends on the sensitivity characteristics of the monopole antenna 5 and the detection accuracy of the oscilloscope 7; however, in the case of the polyimide film 3 used in this example, the vibration frequency of the sound waves radiated by the speaker 1 is preferred to be several-ten Hz to several-hundred Hz. Also in an actual experiment, the static-electricity electrification amount was detected at high accuracy. In this example, the polyimide film 3 is directly attached to the acrylic tube 2; however, the periphery of the polyimide film 3 may be retained by an insulated frame, and the polyimide film 3 may be disposed via a slight gap from the opening of the acrylic tube 2.

The amplitude of the measured object and the electromagnetic-wave intensity generated by the electrified measured object are in a mutually proportional relation, and the detection sensitivity of the electromagnetic waves is improved when the frequency of the sound waves, which increases the amplitude of the measured object, is added. Generally, in the case in which the static-electricity electrification of the entire object is to be measured by vibrating the entire measured object like the polyimide film, it is effective to use low-frequency waves of several Hz to several kHz, with which an amplitude of 1 µm or more can be easily obtained, or sound waves including the frequency (for example, waves synthesized with ultrasonic waves). In any case, it is only desired to obtain the amplitude of 1 µm or more; therefore, depending on the measured object, the speaker 1 may be disposed above the measured object placed on an insulating supporting mount, and the sound waves output from the speaker 1 may be radiated to the measured object. Furthermore, if the measured object has a film-like shape, the measured object can be efficiently vibrated by sound waves having an extremely low sound pressure by supporting the periphery thereof with a frame composed of an insulating body and radiating the sound waves from the speaker to the surface thereof.

On the other hand, in a case in which the measured object is a hard material and is constrained, even when sound waves are partially radiated to the object, vibrations cannot be expected. In such a case, it is preferred to add vibrations to the supporting mount per se, which constrains the measured object. Alternatively, when surface elastic waves (waves which transmit at the surface) having a frequency of several-ten kHz to several-ten MHz, with which an amplitude can be comparatively easily obtained, are generated in the measured object, static-electricity electrification can be measured.

In this manner, the relation between the amplitude of the measured object and the vibration frequency of the sound waves radiated by the speaker 1 are changed depending on the characteristics of the measured object. Therefore, the vibration frequency and the sound pressure of the radiated sound waves can be changed and adjusted to optimal values so that a precise electrification state can be detected. In this process, it is preferred to automatically detect a vibration frequency at which the amplitude is high and feed back the sound pressure at which an optimal amplitude is obtained based on the detection values, etc. of a measurement apparatus such as the oscilloscope 7.

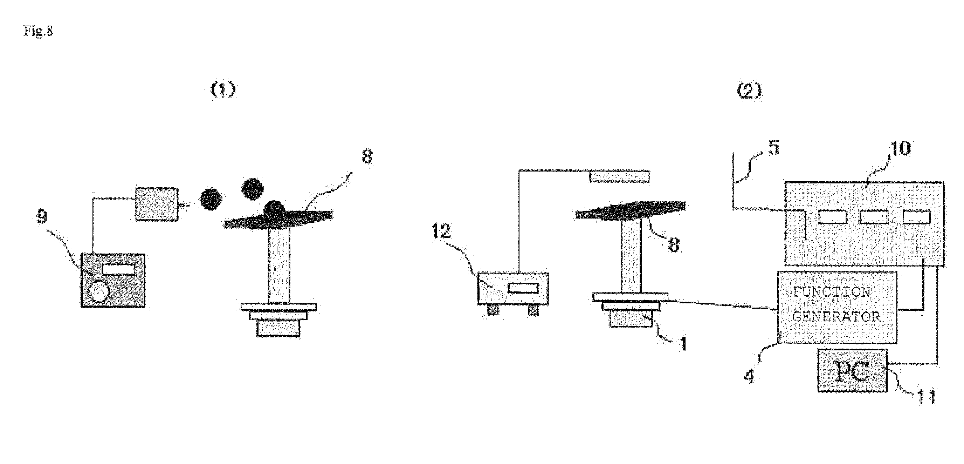

Next, a case in which a copper plate 8 is disposed as a measured object as shown in FIG. 8 (1) will be explained. As well as the case of the polyimide film 3, in an electrically insulated state, the copper plate 8 is uniformly electrified by a corona discharge from a high-voltage power supply 9. Then, as shown in FIG. 8 (2), the speaker 1 adds vibrations to the copper plate 8 via the function generator 4 as well as the polyimide film 3. The static-electricity electrification amount of the copper plate 8 to which the vibrations were added was measured by a surface electrometer 12.

Signals of the function generator 4 and the antenna 5 are connected to a lock-in amplifier 10, which detects the spectrum of a signal segment at a high S/N ratio. The lock-in amplifier 10 measures the electromagnetic-wave intensity and phase detected by the antenna 5 when the copper plate 8 is vibrated, and the measurement data thereof is taken into a computer PC 11.

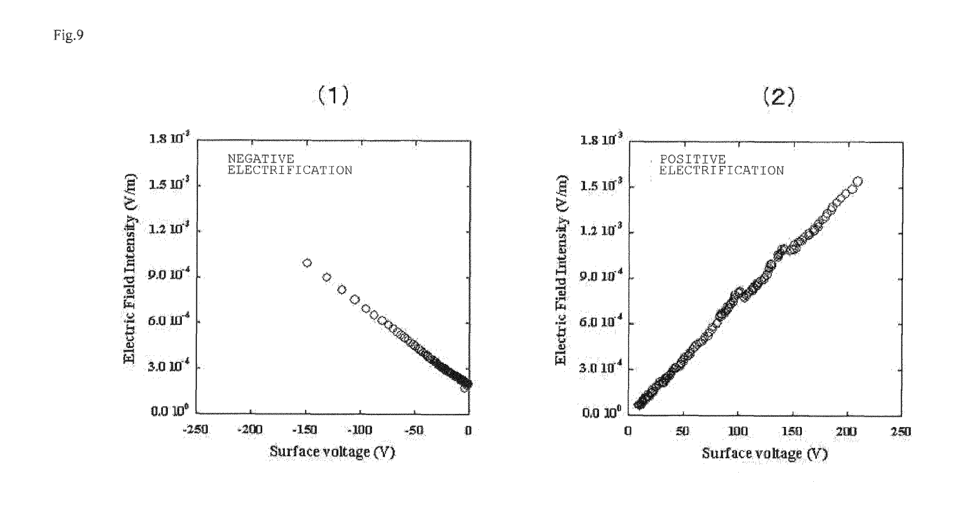

On the other hand, the electric potential of the copper plate 8 is measured by the surface electrometer 12. The relation between the electromagnetic-wave intensity measured by the present invention and the electric potential of the copper plate 8 measured by the surface electrometer 12 is shown in FIG. 9. FIG. 9 (1) shows a case in which the copper plate 8 is negatively electrified, and FIG. 9 (2) shows a case in which the copper plate 8 is positively electrified.

Generally, it is known that there is a relation: Q=CV, wherein the charge amount is Q, the capacity is C, and the voltage is V. Since the electric potential measured by the surface electrometer is proportional to the static-electricity electrification amount of the copper plate 8, the static-electricity electrification amount and the electric potential are equivalent to each other. The results of FIG. 9 show that the electromagnetic-wave intensity measured by the present invention and the electric potential measured by the surface electrometer are proportional to each other. This shows that the surface electric potential can be estimated by measuring the electromagnetic-wave intensity by the static-electricity electrification measurement method of the present invention. Furthermore, it shows that the static-electricity electrification amount Q can be measured by the static-electricity electrification measurement method since the relation between the electromagnetic waves and the static-electricity electrification amount has been proved.

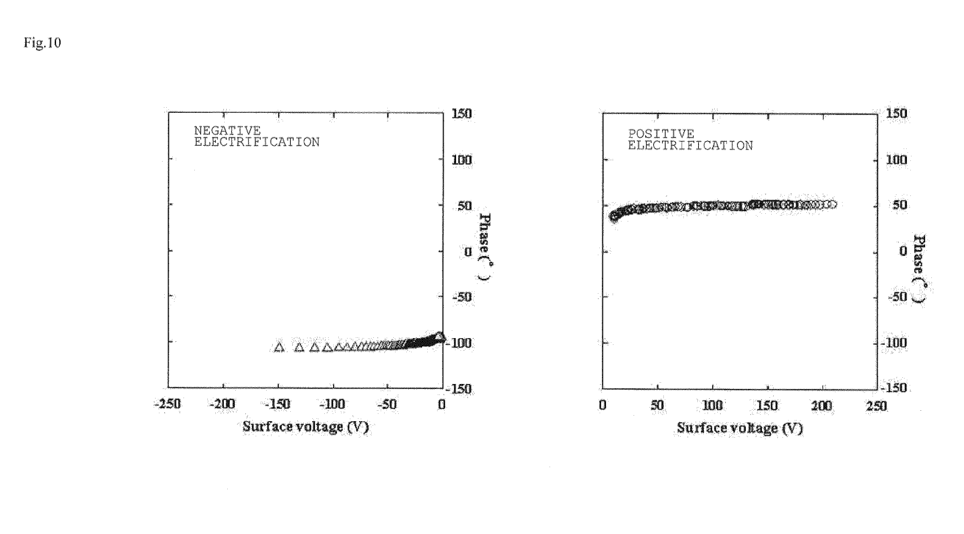

However, even when the electromagnetic-wave intensity generated from the measured object is measured by the method of the present invention, whether the electrification charge is positive or negative is unknown. Therefore, in order to determine positive/negative, FIG. 10 shows the relations between phase angles (Phase) of the electromagnetic waves detected by the antenna 5 and the electric potentials of the copper plate. In this case, the signal of the function generator 4 is used as a comparison signal (reference).

As is understood from these results, in the case of negative electrification of the example, the phase angle (Phase) of the signal representing the electromagnetic-wave intensity is minus (almost -100°). On the other hand, in the case of positive electrification, the phase of the signal representing the electromagnetic-wave intensity is plus (almost +50°). In this manner, positive/negative of the electrification can be reliably determined by utilizing the fact that the phase is different depending on the polarity of the electrification.

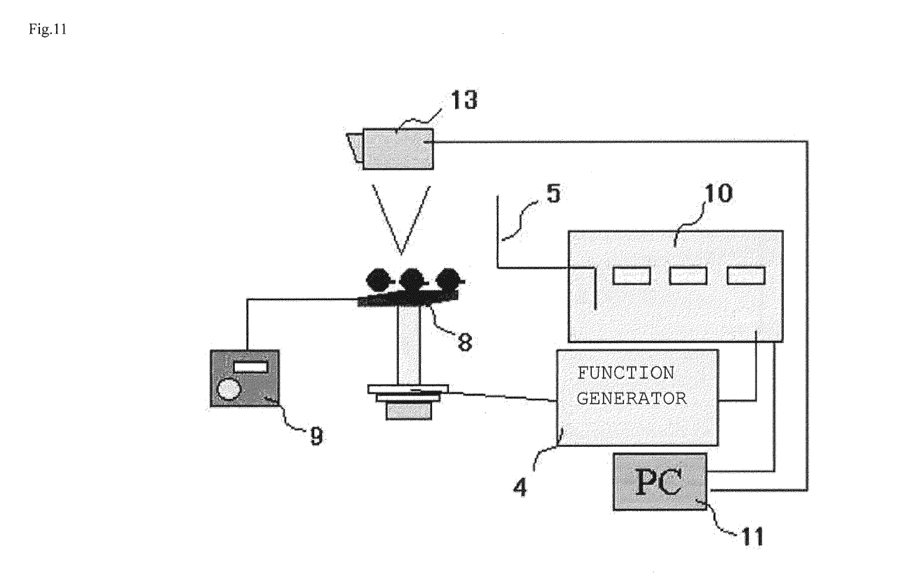

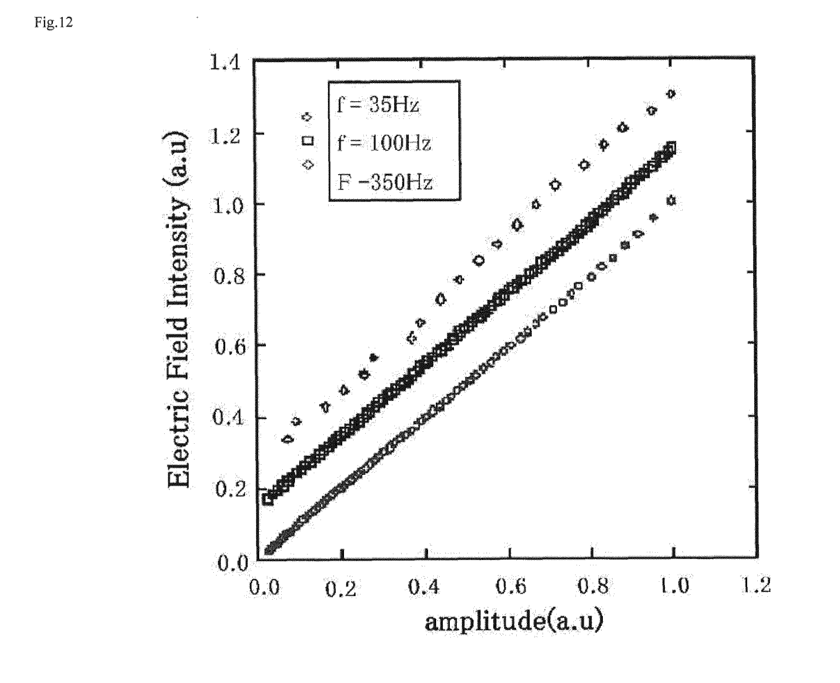

Next, as shown in FIG. 11, upon electromagnetic-wave intensity measurement of the above described copper plate 8, the amplitude of the copper plate 8 is measured by using a laser displacement meter 13. The amount of the measured amplitude is taken into the computer PC 11, and the relation between the measured electromagnetic-wave intensity and the amplitude is measured. FIG. 12 shows the relation between the measured electromagnetic-wave intensity and the amplitude.

In FIG. 12, the horizontal axis shows the amplitude, which has been measured by the laser displacement meter 13 and standardized by frequencies; the vertical axis shows the electromagnetic-wave intensity, which is standardized by the frequencies; and it can be confirmed that the amplitude and the electromagnetic-wave intensity are in a proportional relation. Therefore, the electromagnetic-wave intensity can be increased by increasing the amplitude at any frequency; therefore, sensitivity is improved.

Since the measurement of the electromagnetic-wave intensity in the example is proportional to the amplitude of the measured object, the amplitude of the copper plate 8, which is the measured object, is actually measured by using the laser displacement meter 13 in FIG. 11. However, in a case in which the static-electricity electrification state of the same measured object is to be repeatedly measured, the laser displacement meter 13 is not necessarily required when a map is obtained by measuring, in advance, the relation between the output of the function generator 4 to the speaker 1 and the amplitude of the measured object.

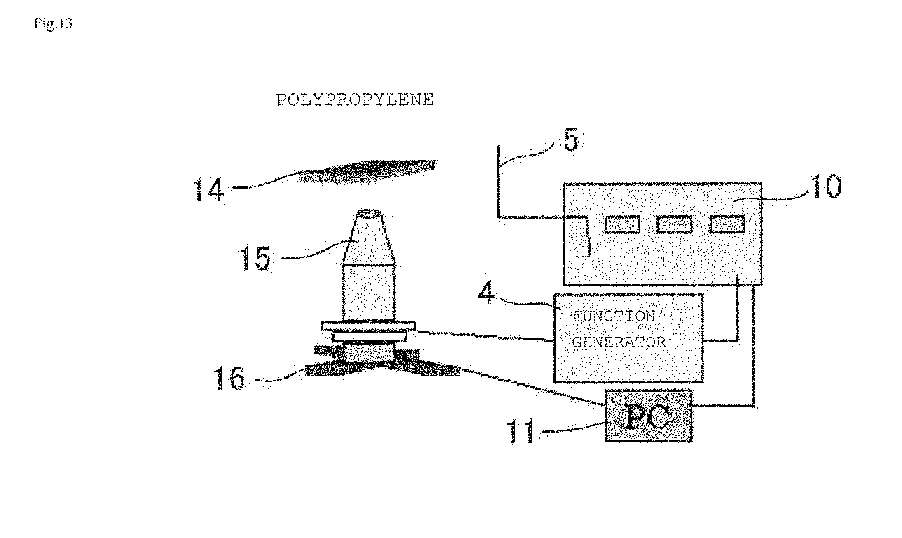

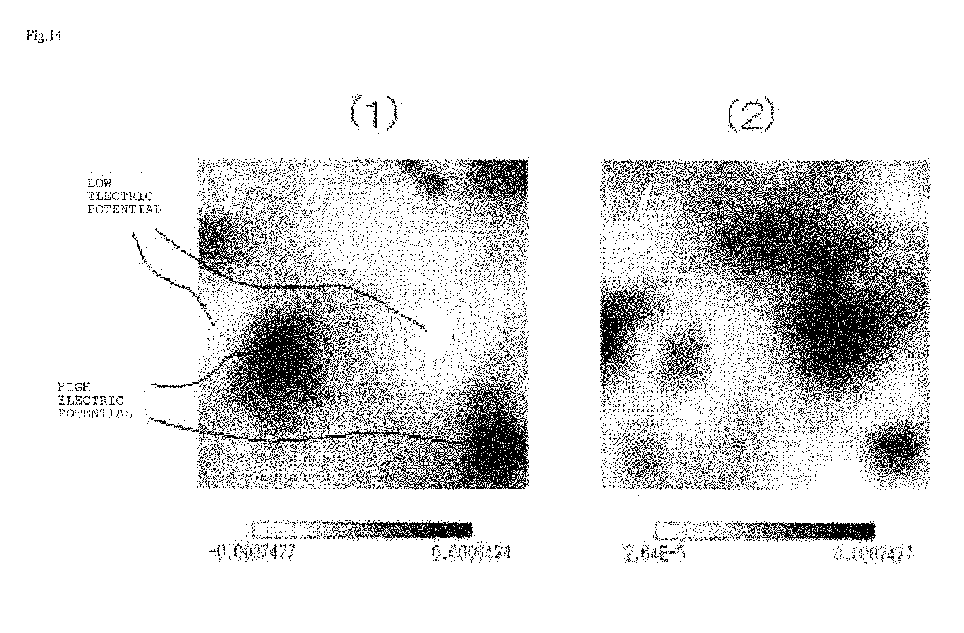

An example shown in FIG. 13 is for measuring the distribution of the static-electricity electrification amount electrified a film made of a synthetic resin. In this case, a polypropylene film 14 is used as a measured object, and the periphery thereof is retained by an unshown insulating body. Instead of the cylindrical acrylic tube 2, a tapered conical acrylic tube 15 is used. The sound waves generated from the speaker 1 installed at a bottom part of the acrylic tube 15 are converged like a dot on a back surface of the polypropylene film 14 by a tapered apex part. At the same time, an x-y stage 16 was controlled by the computer PC 11 to cause a radiation position to carry out scanning in an x-direction and a y-direction, and the electromagnetic-wave intensity received by the antenna 5 was measured by the lock-in amplifier 10 in correspondence with coordinates (x, y) of the scanning position. The measurement results thereof are shown in FIG. 14 (1) and (2).

As described above, FIG. 14 (1) shows the result of identifying negative electrification and positive electrification and calculating in consideration of a phase θ, which is a measurement result of electromagnetic-wave intensity. In the drawing, "-0.0007477 to 0.0006434" represent a smallest value and a largest value.

On the other hand, FIG. 14 (2) ignores the phase and shows the measurement result of the electromagnetic-wave intensity without change. In the drawing, "2.64E-5 to 0.0007477" shows a smallest value and a largest value of this case.

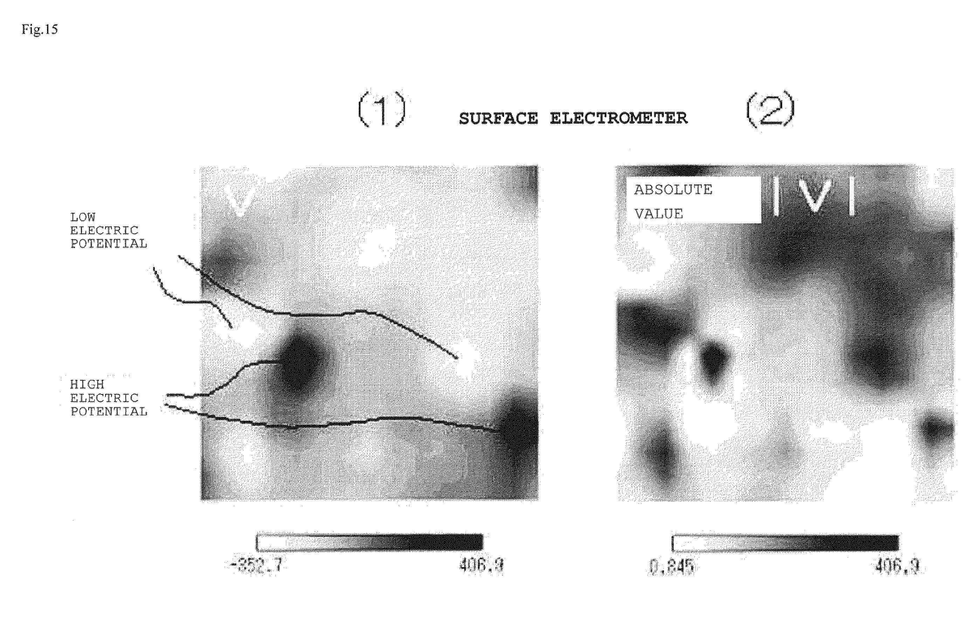

For comparison, surface electric-potential distribution of the polypropylene film 14 measured by using a surface electrometer is shown in FIG. 15 (1) and (2). As the surface electrometer, the surface electrometer of a type utilizing electrostatic induction was used. As well as the above description, the surface electric potential was measured in correspondence with the coordinates (x, y) of the scanning position by using an x-y stage, and the measurement result thereof are shown in FIG. 15.

FIG. 15 (1) "-352.7 to 406.9" shows that the smallest value is -352.7 V, and the largest value is 406.9 V. FIG. 15 (2) shows that the smallest value of absolute values is 0.845 V, and the largest value is 406.9 without identifying negative electrification and positive electrification.

FIG. 15 (1) and (2) have the results corresponding to FIG. 14 (1) and (2), respectively.

As is understood from these results, it was confirmed that the measurement results of the surface electric potential by the static-electricity electrification measurement method of the present invention approximately precisely correspond to the measurement results by the surface electrometer.

In the example, a slight gap is formed between the distal end of the conical acrylic tube 15 and the back surface of the polypropylene film 14 so that they are not in direct contact with each other; however, the distal end of the tapered conical acrylic tube 15 may be configured to be in contact with the back surface of the polypropylene film 14. However, in that case, static electricity may be generated at the contact part along with x-y-direction movement of the distal end of the tapered conical acrylic tube 15; therefore, the distal end part in contact therewith is preferred to be bumpy to reduce the contact area with the polypropylene film 14 and suppress static electricity generation.

In the above descried examples, the sound waves are prevented from diffusing or converged like a dot with respect to the measured object via the cylindrical acrylic tube 2 or the conical acrylic tube 15. However, depending on a measured object, a sound-wave generating device installed at a position separated and distant from the measured object can directly radiate sound waves to the measured object to add vibrations thereto without using the cylindrical acrylic tube 2 or the conical acrylic tube 15 as described above.

Furthermore, in the example of FIG. 13, the conical acrylic tube 15 is used as a sound-wave converging unit, which converges sound waves like a dot on the surface of the measured object. However, it is not limited thereto, and a circular concave lens which converges sound waves by a concave surface, an acoustic lens formed in a convex shape with a material in which the speed of sounds transmitted therein is small such as silicon rubber, or a device such as electronic focusing which converges sound waves by providing a time lag for a plurality of sound sources may be used as the sound-wave converging unit.

Furthermore, depending on the type of the measured obj ect, it is not limited to vibration addition to the measured object by the sound waves from the sound-wave generating device. A vibration generating device may be disposed at, for example, a retention mount which retains the measured object so as to directly vibrate the measured object. Alternatively, vibrations may be locally added to the measured object by converged sound waves or a contact, which can be moved in the x-y direction by using the x-y stage, and the static-electricity electrification amount distribution thereof may be measured.

In the case in which vibrations are directly added to the measured object, the measured object is preferred to be subjected to vacuum suction so that new static electricity is not generated due to, for example, friction between the measured object and the retention mount retaining it. Alternatively, in order to avoid static electricity from being newly generated due to contact between the measured object and the contact, it is preferred to reduce the contact area as much as possible by causing the contact part to be bumpy to bring it into dot-like contact and effectively suppress generation of static electricity caused by the vibrations.

The static-electricity electrification measurement methods explained above may be realized as static-electricity electrification measurement apparatuses.

In this manner, the static-electricity electrification measurement methods and the static-electricity electrification measurement apparatuses of the present invention can measure the state of static-electricity electrification of the measured object by adding sound radiation or directly adding minute vibrations to the measured object so as to generate electromagnetic waves and detecting the electromagnetic waves, for example, by an antenna. As a result, even when the installation location thereof is strictly limited like, for example, semiconductor manufacturing steps, the static-electricity electrification measurement apparatus can be easily installed at a position where the waves can be received by an antenna. Particularly, it can be built with low cost.

Moreover, since measurement with extremely good response can be carried out, when the static-electricity electrification amount exceeds a hazardous value, for example, electrification generation can be suppressed by a ground, or charge relaxation can be promoted by causing an insulator in a manufacturing step to have an electrically-conductive surface. Furthermore, by taking a measure such as electrification neutralization using an ionizer or a soft X-rays, generation of defective products due to, for example, electrostatic breakdown can be effectively prevented. In this point, yield can be improved. Furthermore, in a film coating step, unevenness caused by static-electricity electrification can be prevented from being generated. As a result, high-quality coating can be generated.

### Reference Signs List

- 1: SPEAKER
- 2: ACRYLIC TUBE
- 3: POLYIMIDE FILM
- 4: FUNCTION GENERATOR
- 5: MONOPOLE ANTENNA
- 6: PREAMPLIFIER
- 7: OSCILLOSCOPE
- 8: COPPER PLATE
- 9: HIGH-VOLTAGE POWER SUPPLY
- 10: LOCK-IN AMPLIFIER
- 11: COMPUTER (PC)
- 12: SURFACE ELECTROMETER
- 13: LASER DISPLACEMENT METER
- 14: POLYPROPYLENE FILM
- 15: CONICAL ACRYLIC TUBE
- 16: x-y STAGE

## Claims

1. A static-electricity electrification measurement method including:
an adding step of adding vibrations having a vibration frequency and an amplitude selected in advance to a measured object;
an intensity measuring step of measuring intensity of electromagnetic waves generated along with the vibrations of the measured object; and
a state measuring step of measuring a static-electricity electrification state of the measured object based on the intensity of the electromagnetic waves measured in the measuring step.

2. The static-electricity electrification measurement method according to claim 1, further including:
an amplitude measuring step of measuring an amplitude of the measured object; and
an electrification-amount measuring step of measuring a static-electricity electrification amount of the measured object based on the intensity of the electromagnetic waves measured in said intensity measuring step and the amplitude measured in said amplitude measuring step.

3. The static-electricity electrification measurement method according to claim 1 or 2, further including:
a determination step of determining whether the static-electricity electrification state of the measured object is negative electrification or positive electrification based on a phase of the electromagnetic waves measured in at least one of said intensity measuring step and said amplitude measuring step.

4. The static-electricity electrification measurement method according to any one of claims 1 to 3, wherein,
in said adding step, sound waves having the vibration frequency and a sound pressure selected in advance are radiated to the measured object.

5. The static-electricity electrification measurement method according to any of claims 1 to 3, wherein,
in said adding step, a supporting mount supporting the measured object is vibrated at the vibration frequency and the amplitude selected in advance.

6. The static-electricity electrification measurement method according to claim 4, wherein,
in said adding step, a sound-wave generator that is installed at a bottom part of a cylindrical member and generates the sound waves is provided; and
the measured object is disposed above the cylindrical member.

7. The static-electricity electrification measurement method according to claim 4, wherein
in said adding step, the sound waves are converged by a sound-wave converging unit and add local vibrations to the measured object.

8. The static-electricity electrification measurement method according to claim 7, wherein
the sound-wave converging unit uses at least one of a conical member, a circular concave lens, an acoustic lens, and electronic focusing using a plurality of sound sources for converging the sound waves generated from the sound-wave generator.

9. The static-electricity electrification measurement method according to any one of claims 1 to 3, wherein,
in said adding step, a vibrator having an end to be in contact with the measured object is provided; and
the vibrator and the measured object are brought into contact with each other and vibrated at the vibration frequency and the amplitude selected in advance.

10. The static-electricity electrification measurement method according to any one of claims 7 to 9, wherein,
in said adding step, a position of adding the vibrations to the measured object is scanned; and
in said intensity measuring step, static-electricity electrification distribution of the measured object is measured by measuring the electromagnetic waves in correspondence with the scanned position.

11. A static-electricity electrification measurement apparatus comprising:
a vibration adding unit operable to add vibrations having a predetermined amplitude and frequency to a measured object;
a receiving unit operable to receive electromagnetic waves generated along with the vibrations of the measured object; and
a calculating unit operable to calculate a static-electricity electrification amount, which has electrified the measured object, based on intensity of the electromagnetic waves received by said receiving unit.

12. The static-electricity electrification measurement apparatus according to claim 11, further comprising
a laser displacement meter that measures an amplitude of the measured object.

13. The static-electricity electrification measurement apparatus according to claim 11 or 12, wherein
said calculating unit further has a determination unit operable to determine whether the static-electricity electrification of the measured object is negative electrification or positive electrification based on a phase of the electromagnetic waves received by said receiving unit.

14. The static-electricity electrification measurement apparatus according to any of claims 11 to 13, wherein
said vibration adding unit has a sound-wave generating device operable to radiate sound waves having a vibration frequency and a sound pressure selected in advance to the measured object.

15. The static-electricity electrification measurement apparatus according to any of claims 11 to 13, wherein
said vibration adding unit has a vibration generating device operable to vibrate a supporting mount supporting the measured object at the vibration frequency and the amplitude selected in advance.

16. The static-electricity electrification measurement apparatus according to claim 14, wherein
the sound-wave generating device has a sound-wave generator installed at a bottom part of a cylindrical member; and
the sound-wave generator radiates the sound waves to the measured object disposed above the cylindrical member.

17. The static-electricity electrification measurement apparatus according to claim 14, wherein
the sound-wave generating device has at least one of a sound-wave generator, a circular concave lens, an acoustic lens, and electronic focusing using a plurality of sound sources installed at a bottom part of a conical member; and
the sound-wave generating device radiates converged sound waves to the measured object.

18. The static-electricity electrification measurement apparatus according to any of claims 11 to 13, wherein
said vibration adding unit has a vibrator provided with an end to be in contact with the measured object; and
the vibrator adds the vibrations at the vibration frequency and the amplitude selected in advance at a contact point with the measured object.

19. The static-electricity electrification measurement apparatus according to claim 17 or 18, wherein
said vibration adding unit has an x-y stage that carries out scanning with respect to the measured object; and
the calculating unit measures static-electricity electrification distribution of the measured object by measuring the electromagnetic waves in correspondence with a scanning position of the x-y stage.
